# EUROPEAN PATENT APPLICATION

(11) **EP 3 462 495 A1**
(43) Date of publication of application: **03.04.2019**
(21) Application number: 17306303.3
(22) Date of filing: 29.09.2017
(51) Int. Cl.: H01L 27/146

(54) **ENHANCED LIGHT CAPTURE IMAGE SENSOR**

(71) Applicant: Thomson Licensing, 92130 Issy-les-Moulineaux (FR)
(72) Inventor: DAMGHANIAN, Mitra, 35576 Cesson-Sévigné Cedex (FR); BORISKIN, Artem, 35576 Cesson-Sévigné Cedex (FR); DRAZIC, Valter, 35576 Cesson-Sévigné Cedex (FR)
(74) Representative: Vidon Brevets & Stratégie

(57) **Abstract**

It is proposed an enhanced light capture image sensor comprising an array of pixels, each pixel comprising a micro-lens (ML1), a photosensitive layer (PL) and a colour filter layer (FL) arranged between said micro-lens and photosensitive layers, said image sensor comprising, for at least one pair of adjacent pixels, an optical isolating trench (OT1) placed between the colour filter layers of said adjacent pixels and extending from the micro-lenses of said adjacent pixels.

## Description

### 1. TECHNICAL FIELD

The present disclosure relates to the field of imaging devices. More specifically, the present disclosure relates to image sensor design. The present disclosure applies to any kind of image sensor, such as BSI or FSI architecture sensor for example.

### 2. BACKGROUND

The present section is intended to introduce the reader to various aspects of art, which may be related to various aspects of the present invention that are described and/or claimed below. This discussion is believed to be helpful in providing the reader with background information to facilitate a better understanding of the various aspects of the present invention. Accordingly, it should be understood that these statements are to be read in this light, and not as admissions of prior art.

Image sensors are widely used in consumer electronic devices such as smartphones and various digital cameras. At present, there are two types of image sensor available for mass products, namely CCD (for "Charge Coupled Devices") and CMOS (for "Complementary Metal-Oxide-Semiconductor").

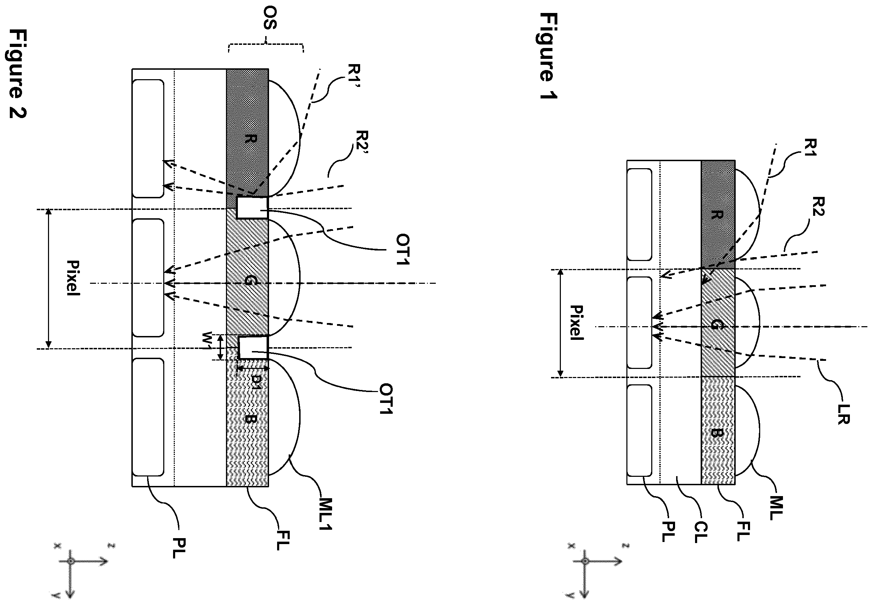

Conventional image sensors comprise an ordered array of pixels. A pixel is a photosensitive element which converts incident light into electrical signals. As shown on Figure 1, each pixel of the array comprises a micro-lens ML, a photosensitive layer PL and a colour filter layer FL, placed between the micro-lens ML and photosensitive layer PL. The micro-lens ML captures and guides the incident light LR towards the photosensitive layer PL through the colour filter layer FL. The colour filter layer FL, of Bayer type for instance, lets pass only one of RGB components of light signal coming from the micro-lens ML. The photosensitive layer (also commonly called "photodiode") PL converts the filtered light components into an electrical signal. The electrical signals produced by the array of pixels are then processed to generate an image.

CMOS pixels can be classified into two categories: frontside illuminated (FSI) structure and backside illuminated (BSI) structure. In FSI structure, incident light first passes through a circuitry layer CL before reaching the photoactive region of the pixel, whereas in a BSI structure, the position of the metal layer is flipped with the position of the photoactive region of the pixel.

The amount of electrical charges generated by the photodiode depends on the number of photons reaching the photodiode. It is therefore crucial that the entire incident light captured by the micro-lens is guided and received by the photodiode.

However, in practice, especially for image sensors having closely located pixels, some of incident light rays reach an unintended photodiode of the sensor, either because of poor guidance to the intended photodiode or by mechanisms such as reflection and/or refraction. This phenomenon, called optical crosstalk, predominantly exists between 'neighboring pixels' (this will be hereafter referred to as 'adjacent pixels'). For example, as shown in Figure 1, the incoming light rays R1 and R2 initially intended to the photodiode of the red pixel (R) get refracted by the micro-lens toward the photodiode of the adjacent green pixel (G). Therefore a part of incoming light is not only collected by the photodiode of the red pixel but it also is received as unintended additional light by the adjacent photodiode.

Optical crosstalk degrades quality of images produced by the imaging device and undermines the light capture efficiency of the sensor. These undesirable results (such as blurring, reduction in contrast, reduction in sensitivity, reduction in image sharpness, color mixing, etc.) are intrinsic to all image sensors and are especially critical for backside illumination (BSI) image sensors (a BSI structure generally captures a wider cone of light compared to a FSI structure).

This problem becomes more pronounced as the density of pixels per surface unity increases and as the pixel size decreases. Indeed, the thickness of a small size pixel sensor cannot be scaled with the same rate as the pixel surface dimensions. Moreover the photodiode depth should be higher than a given threshold to ensure acceptable sensitivity (for example, in order to ensure red sensitivity, for a pixel width of around 1 µm, the photodiode depth should be larger than 3 µm). However, the higher the photodiode depth is, the smaller the aperture to depth ratio is, thereby making it difficult to properly focus incident light onto the photodiode surface.

It should also be noted that optical crosstalk is more pronounced as the incident angle (angle comprised between the incident light and the normal to the micro-lens surface, also called acceptance angle) increases. Indeed, the bigger the incident angle of light rays is, more susceptible the incident light to end up in an adjacent pixel is.

A known method of reducing optical crosstalk, disclosed in US20090200625, uses an electrical and optical isolation trench within the photodiode thickness of a BSI pixel. However the presence of such isolation trench within the silicon bulk of the pixel is not ideal and only prevents partially optical crosstalk.

Another known solution, as disclosed in US8940574, uses metal grid apertures between adjacent pixels of the image sensor. However these metal grid apertures reflect back part of the incident light, which reduces the amount of light becoming to the photodiodes. Moreover, this kind of structure is complex and costly to implement.

Another known solution, as disclosed in WO2007024580**,** uses an optically reflecting barrier that is partially extended within and between the color filter layers of adjacent pixels, in order to improve the optical crosstalk immunity. However such an optical barrier does not allow a optical spatial confinement sufficient to efficiently reduce optical crosstalk between adjacent pixels.

There is therefore a need for a solution for efficiently reducing optical crosstalk and enhancing light capture efficiency of image sensors.

### 3. SUMMARY OF THE DISCLOSURE

References in the specification to "one embodiment", "an embodiment", "an example embodiment", indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described.

A particular embodiment of the disclosure proposes an image sensor comprising an array of pixels, each pixel comprising a micro-lens, a photosensitive layer and a colour filter layer arranged between said micro-lens and photosensitive layers, said image sensor comprising, for at least one pair of adjacent pixels, an optical isolating trench placed between the colour filter layers of said adjacent pixels, and extending from the micro-lenses of said adjacent pixels.

Thus, thanks to the presence of such an optical isolating trench between two adjacent pixels, the incoming light rays remain spatially confined from the micro-lenses of the adjacent pixels up to they reach the photosensitive layers thereof. Such approach makes it possible to efficiently reduce optical crosstalk between the adjacent pixels.

According to a first particular implementation, said optical isolating trench extends from a perimeter of each of the micro-lenses.

According to a second particular implementation, said optical isolating trench extends from a portion of surface of a lower face of the micro-lenses.

According to a third particular implementation" said optical isolating trench extends from a portion of surface of an upper face of the micro-lenses.

According to a particular feature, said optical isolating trench comprises at least one filling material having a first refractive index, said micro-lenses and colour filter layers of said adjacent pixels having second and third refractive indexes respectively, and wherein the first refractive index being lower than each of the second and third refractive indexes.

This difference in refractive index with respect to the micro-lenses and colour filter layers causes internal optical reflections allowing keeping the light rays spatially confined from the micro-lenses up to they reach the photosensitive layer of the pixel.

According to a particular feature, the first refractive index is lower than 1.5.

According to a particular feature, the material of said optical isolating trench belongs to the group comprising: polymer, oxide, air.

The material is chosen for its optical reflection properties. Indeed, the optical isolation trench shall act as an optically reflecting barrier that militates against optical crosstalk between the pair of adjacent pixels.

According to a particular feature, said optical isolating trench has a width lower than 500 nm.

According to a particular feature, said optical isolating trench has a depth lower than 5 000 nm.

According to a particular feature, said optical isolating trench has a cross-sectionally shape belonging to the group comprising: a parallelogram shape, a trapezoidal shape, or drop shape.

The optical isolating trench can be parallelogram-shaped, such as rhomboid, rectangle or square.

According to a particular feature, said optical isolating trench has sidewalls having an inclination depending on the relative position of said optical isolating trench with respect to a main optical axis of said image sensor.

According to a particular feature, said optical isolating extends over at least one portion of a frontier separating said adjacent pixels.

According to a particular feature, each pixel of said array is of a back-side illumination type or front-side illumination type.

Another particular embodiment of the disclosure proposes an Imaging device comprising an image sensor according to any one of the embodiments described above.

### 4. LIST OF FIGURES

Other features and advantages of embodiments of the invention shall appear from the following description, given by way of an indicative and non-exhaustive examples and from the appended drawings, of which:
- **Figure 1**, already described with reference to the prior art, presents a cross section of a part of a CMOS image sensor comprising three pixels of FSI structure;
- **Figure 2** presents a cross-section view of a part of a CMOS image sensor comprising three pixels according to a first particular embodiment of the present disclosure;
- **Figure 3** presents a cross-section view of a part of a CMOS image sensor comprising three pixels according to a second particular embodiment of the present disclosure;
- **Figure 4** presents a cross-section view of a part of a CMOS image sensor comprising three pixels according to a third particular embodiment of the present disclosure;
- **Figures 5a-5b** present a top view of a part of a CMOS image sensor illustrating the presence of optical isolating trenches between adjacent pixels, according to two particular embodiments of the present disclosure;
- **Figures 6a-6d** present, in cross section view, different possible shapes of optical isolating trench according to the present disclosure;
- **Figures 7a-7b** present, in cross section view, different examples of filling of the optical isolating trench according to the present disclosure.

### 5. DETAILED DESCRIPTION

In all of the figures of the present document, identical elements are designated by the same numerical reference sign.

As it will be described more fully hereafter with reference to the accompanying figures, it is proposed in one aspect of the present disclosure to an image sensor using an optical isolating element between adjacent pixels of FSI structure in order to improve light capture of that image sensor. This disclosure may, however, be embodied in many alternate forms and should not be construed as limited to the embodiments set forth herein. Accordingly, while the disclosure is susceptible to various modifications and alternative forms, specific embodiments thereof are shown by way of example in the drawings and will herein be described in detail. It should be understood, however, that there is no intent to limit the disclosure to the particular forms disclosed, but on the contrary, the disclosure is to cover all modifications, equivalents, and alternatives falling within the spirit and scope of the disclosure as defined by the claims. Like numbers refer to like elements throughout the description of the figures.

It will also be understood that, although the terms first, second, etc. may be used herein to describe various elements, these elements should not be limited by these terms. These terms are only used to distinguish one element from another. For example, a first element could be termed a second element, and, similarly, a second element could be termed a first element without departing from the teachings of the disclosure.

While not explicitly described, the present embodiments and variants may be employed in any combination or sub-combination.

The present invention relates to the presence of an optical isolating trench positioned between the colour filter layers of pairs of adjacent pixels and extending from the micro-lenses of these adjacent pixels in order to make it possible to get a more efficient spatial confinement of the incoming light within the pixel structure and thereby reduce the inter-pixel crosstalk phenomenon.

In the present disclosure, the term "pixel" refers to a basic element or elementary cell of an image sensor converting incident light into electrical signals, which can then be processed and stored in the circuitry of the image sensor. For purpose of illustration, figures and the description below of the present disclosure only refer to a limited number of pixels. The principle of the present disclosure can be applied to higher number of pixels, especially (but not limited to) all pixels of the image sensor. In addition, although the disclosure described below with reference to pixels of FSI structure, the disclosure applies to other known structures of pixel, e.g. BSI pixels or CCD pixels.

**Figure 2** is a cross-section view of a part of a CMOS image sensor showing three pixels RGB according to a first particular embodiment of the present disclosure.

The CMOS image comprises an ordered array of pixels of FSI structure. The array of pixels, in rectangular shape for example, comprises a RGB colour filter array disposed according to a predetermined Bayer arrangement (also called "Bayer mosaic") between an array of micro-lens and an array of photodiodes. The micro-lenses are distributed in surface (i.e. in the xy-plane) of the colour filters with a constant distance between two adjacent micro-lenses, hereafter referred to as inter-lens distance.

Each pixel (thereafter referred to as pixel R, G or B) comprises a micro-lens ML1, a photosensitive layer PL and a colour filter layer FL arranged between the micro-lens ML and the photosensitive layers PL. The micro-lens and colour filter layers form the optical stack (OS) of the pixel and are of refractive indexes n₂ and n₃ respectively. The colour filter R lets pass only the red component of light ray coming from the micro-lens ML1, the colour filter G lets pass only the green component of light ray coming from the micro-lens ML1 and the colour filter B lets pass only the blue component of light ray coming from the micro-lens ML1.

In FSI structure, a metal layer (composed of circuitry and metal wires) is disposed between the colour filter layer FL and the photosensitive layer PL of each pixel so that the incident light passes through this metal layer before reaching the photoactive region of the pixel.

In this first particular embodiment, the image sensor comprises for each pair of adjacent pixels (e.g. the pixels R and G) an optical isolating trench OT1 placed between the colour filter layers FL of the adjacent pixels and which extends from the perimeter of each of the micro-lenses ML and partially within colour filter layers FL. In this way, the isolating trench OT1 has a first end positioned within the colour filter layers of the adjacent pixels and a second end in contact with the micro-lenses of the adjacent pixels.

The isolating trench OT1 has a rectangular shape (with a cross-section view in the yz-plane) and comprises a material of refractive index n₁ that is lower than that of micro-lenses and colour filter layers of the adjacent pixels. In other words the optical isolating trench OT1 comprises a material of refractive index n₁ such that n₁ < n₂ and n₁ < n₃.

The material of the isolating trench OT1 is designed to provide internal reflections of incoming light rays within a same pixel structure so as to maintain the light rays spatially confined within this pixel, from the micro-lenses ML up to the photosensitive layer PL through the colour filter layer FL of this pixel.

As shown in Figure 2, the incoming light rays R1' and R2' are refracted by the micro-lens ML of the pixel R, then reflected by the sidewalls of isolating trench OT1 toward the photodiode of the pixel R. Thus, blocking light rays R1' and R2' from passing from the pixel R to the adjacent pixel G, such isolating trench helps to reduce optical crosstalk.

Typically, for a micro-lens of refractive index n₂ = 1.5 and colour filter of refractive index n₃ = 1.5, the isolating trench OT1 placed between the adjacent pixels R and G is filled with a material (hereafter called "filling material") having a refractive index n₁ lower than 1.5, and more particularly a refractive index n₁ lower than 1.4. For example, air is a well-suited optical material for the isolating trench due to its low refractive index (n₁ = 1.0) in comparison with the materials surrounding it. Such a material acts as an efficient optical reflection barrier that helps to reduce optical crosstalk.

Other materials can be used within the isolating trench OT1 provided that they have the aforesaid optical reflection properties, such as: polymers, metallic oxides, silicon oxides, glass oxides or a combination thereof.

It should be noted that greater is the difference in refractive index with respect to the micro-lenses and colour filters, better is the optical isolation provided by the trench, and greater is the acceptance angle (angle comprised between the incident light and the normal to the micro-lens surface). Indeed, the bigger the incident angle of light rays is, more susceptible the incident light to end up in an adjacent pixel is.

The isolating trenches for FSI sensor have a depth D1 of less than 5 000 nm and are generally comprised around about 1 000 to 3 000 nm, and a width W1 of less than 500 nm and are generally comprised around about 50 to 200 nm. Here the width W1 is equal about to the inter-lens distance (which separates two adjacent micro-lenses).

The depth and width of the isolating trenches can be tailored depending on the structure and dimensions of the pixels, especially depending on depth of the colour filter layer FL and the spacing between micro-lenses ML. Generally it appears that the deeper the trench OT1 the better is the optical isolation between adjacent pixel. A deeper trench may better inhibit the light rays from going to an adjacent pixel thereby preventing crosstalk between adjacent pixels.

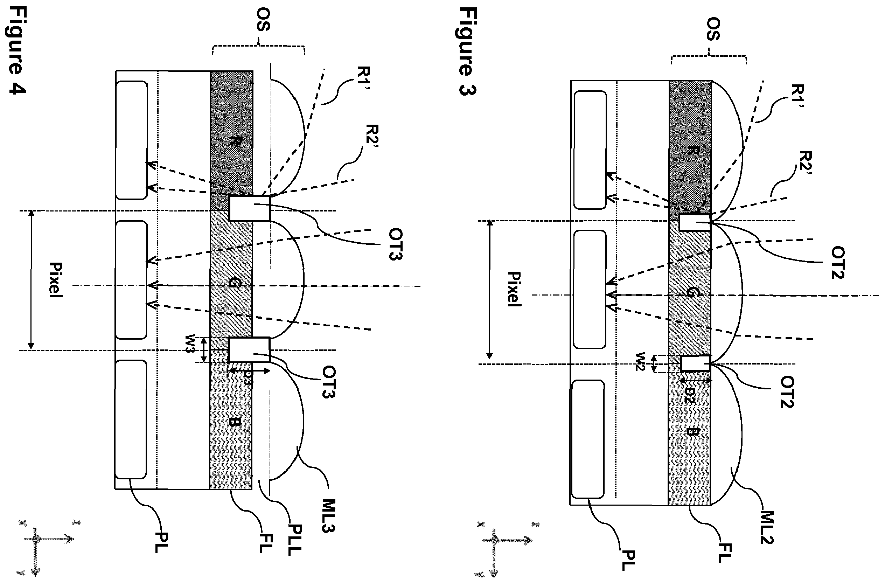

**Figure 3** is a cross-section view of a part of a CMOS image sensor showing three pixels RGB according to a second particular embodiment of the present disclosure.

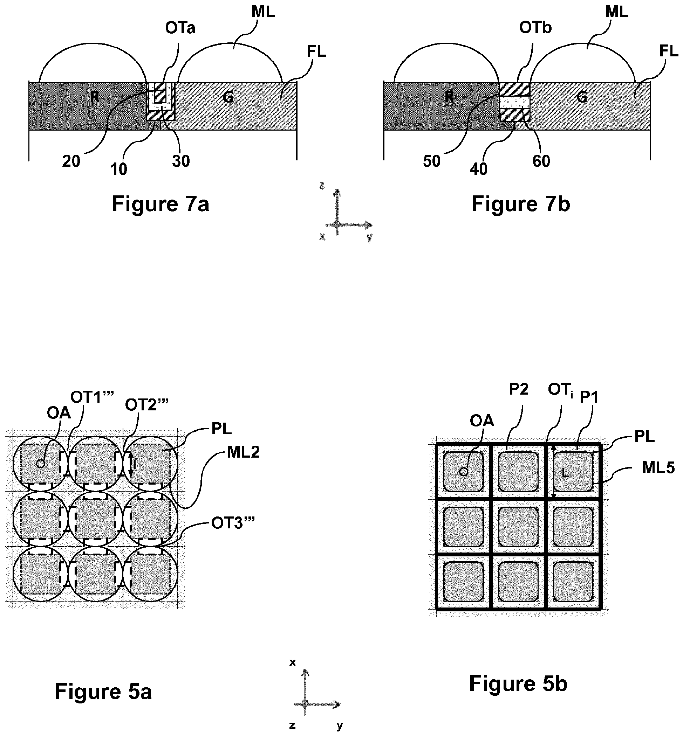

In this second embodiment, unlike the array of micro-lenses ML1 shown in figure 2, the array of micro-lenses ML2 has no inter-lens distance. Indeed, the micro-lenses ML2 are distributed contiguously in the surface of the RGB colour filters (i.e. in the xy-plane) so that they are in contact with each other. This particular distribution of micro-lenses is also shown in **figure 5** in which the peripheries of the micro-lenses are continuous to each other. Thus, in this second embodiment, the optical isolating trench OT2 (which is placed between the colour filter layers FL of the adjacent pixels) extends from a portion of surface of the lower face of the corresponding micro-lenses ML2. The optical isolating trench OT2 further extends partially within colour filter layers FL with a depth D2 and a width W2. In this way, the isolating trench OT2 has a first end positioned within the colour filter layers of the adjacent pixels and a second end in contact with the lower face of the micro-lenses of the adjacent pixels.

The other features detailed in reference with the embodiment of figure 2 can be also applied to the present embodiment of figure 3.

Figure 4 is a cross-section view of a part of a CMOS image sensor showing three pixels RGB according to a third particular embodiment of the present disclosure.

In this third embodiment, unlike the array of micro-lenses ML2 shown in figure 2, the array of micro-lenses ML3 is distributed in surface of a planarization layer PLL with a constant inter-lens distance.

Thus, in this third embodiment, the optical isolating trench OT3 (which is placed between the colour filter layers FL of the adjacent pixels) extends from a portion of surface of the upper face UF of the corresponding micro-lenses ML3. The optical isolating trench OT3 further extends through the protective layer and partially within colour filter layers FL with a depth D3 and a width W3. In this way, the isolating trench OT3 has a first end positioned within the colour filter layers of the adjacent pixels and a second end in contact with the upper face of the micro-lenses of the adjacent pixels.

The other features detailed in reference with the embodiment of figure 2 can be also applied to the present embodiment of figure 4.

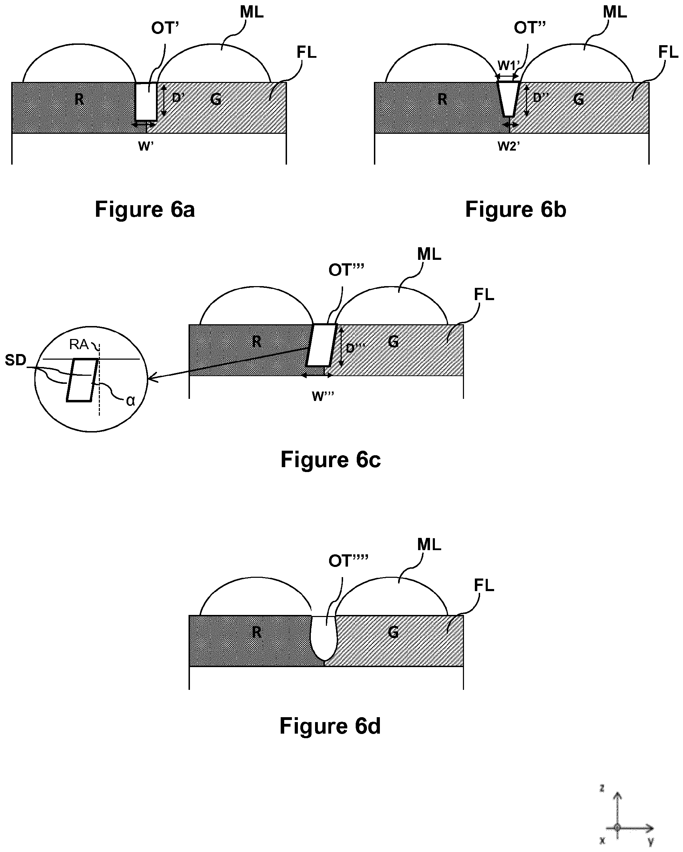

**Figures 6a-6d** presents, in cross section view (i.e. in the yz-plane), four different shapes of optical isolating trench that can be implemented in the first embodiment described above.

The isolating trench OT' has a rectangular cross-sectionally shape (i.e. a parallelogram shape with right angles), with a width W' and sidewalls of depth D'.

The isolating trench OT" has a trapezoidal cross-sectionally shape with an upper base of width W1", a lower base of width W2" and depth D". In this example, this is an isosceles trapezoidal shape (the two adjacent base angles have the same dimensions).

The isolating trench OT'" has a rhomboid cross-sectionally shape (i.e. parallelogram-shaped whose adjacent sides are unequal and with acute angles), with upper and lower sides of same dimension W'" and a depth D"'. Sidewalls of the isolating trench OT'" are referred to as SD on the figure 6c.

The isolating trench OT"" shown in figure 6d has a drop cross-sectionally shape.

The shapes or patterns of isolating trench are presented here as a purely illustrative example. The shapes and dimensions are of course not restricted to these examples but depend on the structural and dimensional features of the image sensor implemented in the context of the present disclosure.

Furthermore, according to a particularly advantageous feature, the shape of optical an isolating trench can be designed depending on the position of the considered adjacent pixels with respect to the main optical axis (OA) of the image sensor.

Let's take the rhomboid shape of figure 6c. The isolating trench OT'" has sidewalls SD having a predefined inclination with respect to the reference axis RA (inclination angle α comprised between the sidewall SD and the reference axis RA). In order to increase the light capturing efficiency, the isolating trenches of the image sensor are designed so that the inclination of sidewalls SD of each isolating trench OT'" depends on the relative position of said isolating trench OT'" with respect to the main optical axis of the image sensor. Greater is the distance separating the isolating trench OT'" from the optical axis, greater is the inclination of sidewalls SD of the isolating trench OT"'. For example, the sidewalls of the isolating trench OT2"', as shown in figure 5, have an inclination upper than that of the isolating trench OT1"' due to its respective positions relative to the main axis OA.

It should be noted that as the isolating trenches OT1"' and OT2'" are disposed on the same axis Y, the inclination angle α comprises only one component. It is clear that, for isolating trenches that are disposed in the xy-plane but out-axis (for example the isolating trench OT3"'), the inclination angle α associated with these trenches comprises two components.

It should be noted that this principle of predefined inclination of sidewalls can also be applied, for instance, to the trapezoidal-shaped isolating trench OT" without departing from the scope of the disclosure.

**Figures 7a** and **7b** presents, in cross section view, two other examples of filling of the optical isolating trench according to the present disclosure.

The rectangular-shaped isolating trench illustrated below in relation with figures 2, 3, 4 and 6a comprises one filling material.

According to the particular embodiments shown in figures 7a and 7b, the optical isolating trenches OTa and OTb each comprises two filling materials arranged differently:
- a first filling material of refractive index n₄, such that n₄ < n₂ and n₄ < n₃;
- a second filling material of refractive index n₅, such that n₅ < n₂ and n₅ < n₃.

For example, the first material is polymer-based material and the second material is metal oxide-based material. But other materials, such as those discussed above, can be used without departing from the disclosure. These two filling materials aim at forming an optical barrier to the light rays in a manner that the incoming light rays remain spatially confined within a same pixel (from the micro-lenses to the photosensitive layer of that pixel).

As shown in figure 7a, the optical isolating trench OTa comprises:
- a first trench region 10 of U-shaped, made up of the first filling material (n₄), covering the inner walls of the trench which are in contact with the colour filter layers FL (hatched region);
- a second trench region 20 of rectangular-shaped, made up of the first filling material (n₄), extending partially from the colour filter layer surface in the center of the trench (hatched region) ;
- a third trench region 30 of U-shaped, made up of the second filling material (n₅), comprised between the first and second regions (spotted region).

As shown in figure 7b, the optical isolating trench OTb comprises:
- a first rectangular trench region 40, made up of the first filling material (n₄), extending over the surface of the lower inner wall of the trench (hatched region);
- a second rectangular trench region 50, made up of the first filling material (n₄), extending over the surface of the upper inner wall of the trench (hatched region);
- a third rectangular trench region 60, made up of the second filling material (n₅), comprised (or sandwiched) between the first and second trench regions (spotted region).

These two particular structures of isolating trench discussed here have the effect of further reducing optical crosstalk, while providing a better mechanical strength of the isolating trench.

Other embodiments can be implemented without departing from the scope of the present disclosure. For example, the first, second and third trench regions discussed above can make up of first, second and third filling materials of n₄, n₅ and n₆ refractive indexes respectively.

Referring again to Figure 5a, there is shown a particular array of micro-lenses in which the micro-lenses are circular and in contact each other (which the peripheries of the micro-lenses are continuous to each other). In this particular embodiment, each optical trench extends over a central portion of the frontier separating two adjacent pixels (referred to as longer 'l' on figure 5a).

Referring now to Figure 5b, the part of image sensor comprises an array of micro-lenses ML5 in which the micro-lenses ML5 have a rounded corner square shape and are distributed in surface in the xy-plane with a given inter-lens distance. In this particular embodiment, for each pair of adjacent pixels (e.g. P1 and P2), the optical trench OTᵢ extends over the entire longer 'L' of the frontier separating the adjacent pixels P1 and P2. Therefore, for a pixel that is surrounded by four adjacent pixels, this pixel is regarded as being surrounded by an optical trench covering the full inner perimeter of this pixel.

Other shapes and/or distributions of micro-lenses are possible and it is within the knowledge of one skilled in the art to affect the principle of optical isolating trench described above (in any of its different embodiments) in connection with other types of micro-lens array.

## Claims

1. Image sensor comprising an array of pixels, each pixel comprising a micro-lens (ML1; ML2; ML3), a photosensitive layer (PL) and a colour filter layer (FL) arranged between said micro-lens and photosensitive layers, said image sensor comprising, for at least one pair of adjacent pixels, an optical isolating trench (OT1; OT2; OT3) placed between the colour filter layers of said adjacent pixels, **characterized in that** said optical isolating trench extends from the micro-lenses of said adjacent pixels.

2. Image sensor according to claim 1, wherein said optical isolating trench extends from a perimeter of each of the micro-lenses (ML1).

3. Image sensor according to claim 1, wherein said optical isolating trench extends from a portion of surface of a lower face of the micro-lenses (ML2).

4. Image sensor according to claim 1, wherein said optical isolating trench extends from a portion of surface of an upper face of the micro-lenses (ML3).

5. Image sensor to any one of claims 1 to 4, wherein said optical isolating trench comprises at least one filling material having a first refractive index (n₁), said micro-lenses and colour filter layers of said adjacent pixels having second (n₂) and third (n₃) refractive indexes respectively, and wherein the first refractive index being lower than each of the second and third refractive indexes.

6. Image sensor according to claim 5, wherein the first refractive index is lower than 1.5.

7. Image sensor according to any one of claims 5 and 6, wherein said at least one filling material belongs to the group comprising: polymer, oxide, air.

8. Image sensor according to any one of claims 1 to 7, wherein said optical isolating trench has a width lower than 500 nm.

9. Image sensor according to any one of claims 1 to 8, wherein said optical isolating trench has a depth lower than 5 000 nm.

10. Image sensor according to any one of claims 1 to 9, wherein said optical isolating trench has a cross-sectionally shape belonging to the group comprising: a parallelogram shape, a trapezoidal shape, or a drop shape.

11. Image sensor according to any one of claims 1 to 10, wherein said optical isolating trench has sidewalls having an inclination depending on the relative position of said optical isolating trench with respect to a main optical axis of said image sensor.

12. Image sensor according to any one of claims 1 to 11, wherein said optical isolating extends over at least one portion of a frontier separating said adjacent pixels.

13. Image sensor according to any one of claims 1 to 12, wherein each pixel of said array is of a back-side illumination type (BSI) or front-side illumination type (FSI).

14. Imaging device **characterized in that** it comprises an image sensor according to any one of claims 1 to 13.
